(19) Europäisches Patentamt
European Patent Office
Office européen des brevets

(11) EP 2 020 694 A1

(12) # EUROPEAN PATENT APPLICATION

published in accordance with Art. 153(4) EPC

(43) Date of publication:
**04.02.2009 Bulletin 2009/06**

(21) Application number: **07741582.6**

(22) Date of filing: **13.04.2007**

(51) Int Cl.:
***H01L 51/50*** (2006.01) ***C09K 11/06*** (2006.01)

(86) International application number:
**PCT/JP2007/058146**

(87) International publication number:
**WO 2007/123061 (01.11.2007 Gazette 2007/44)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **20.04.2006 JP 2006116466**

(71) Applicant: **Idemitsu Kosan Co., Ltd.**
**Chiyoda-ku**
**Tokyo 100-8321 (JP)**

(72) Inventors:
- **FUKUOKA, Kenichi**
**Sodegaura-shi**
**Chiba 299-0293 (JP)**
- **HOSOKAWA, Chishio**
**Sodegaura-shi**
**Chiba 299-0293 (JP)**
- **MORISHITA, Hironobu**
**Sodegaura-shi**
**Chiba 299-0293 (JP)**
- **KUMA, Hitoshi**
**Sodegaura-shi**
**Chiba 299-0293 (JP)**

(74) Representative: **Gille Hrabal Struck Neidlein Prop Roos**
**Patentanwälte**
**Brucknerstrasse 20**
**40593 Düsseldorf (DE)**

(54) **ORGANIC LIGHT-EMITTING DEVICE**

(57) An organic light-emitting device (1) including, arranged in the following order: an anode (10), an emitting layer (40), a donor-containing layer (50), an acceptor-containing layer (60) and a cathode (70), the donor-containing layer (50) containing at least one selected from a donor metal, a donor metal compound and a donor metal complex.

FIG. 1

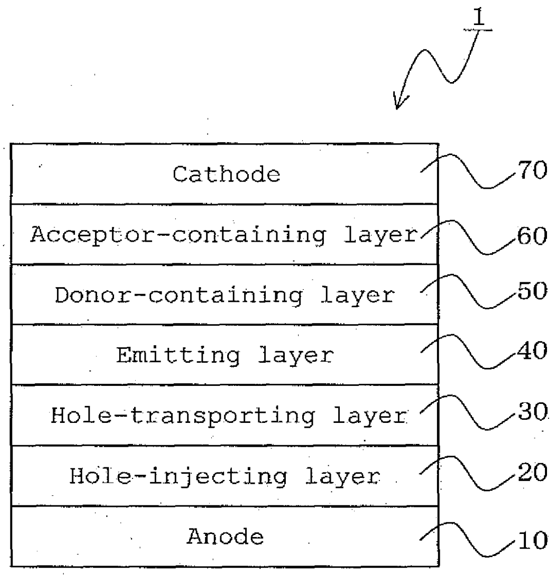


EP 2 020 694 A1

Printed by Jouve, 75001 PARIS (FR)

**Description**

TECHNICAL FIELD

The invention relates to an organic light-emitting device, in particular, to an organic electroluminescence (EL) device.

BACKGROUND ART

An EL device utilizing electroluminescence has a high degree of visibility due to the self-emitting nature thereof. In addition, being a perfect solid device, it has benefits such as excellent impact resistance. For these reasons, use of an EL device as a light-emitting device in various displays has attracted attention.
The EL device is divided into an inorganic EL device using an inorganic compound as an emitting material, and an organic EL device using an organic compound as an emitting material. Of these, an organic EL device has been developed as a next-generation emitting device, since it can significantly reduce an applied voltage, can easily attain full-color display, consumes only a small amount of power and is capable of performing plane emission.
Although an organic EL device basically comprises an anode, an emitting layer and a cathode being stacked in this order, various device configurations are studied with the aim of developing an organic EL device having a high efficiency and a long lifetime.
For example, Patent Document 1 discloses a light-emitting device having the configuration of: an anode/an n-type organic compound layer/a p-type organic compound layer/an emitting layer/a cathode.
However, in this device configuration, difference in affinity level between the n-type organic compound layer and the p-type organic compound layer is large. Therefore, electrons injected to the n-type organic compound layer from the anode, to which a negative bias voltage has been applied, are not transported to the p-type organic layer over the interface. For this reason, this device does not emit light even though a negative bias voltage is applied to the anode of this device.
Patent Document 2 discloses a light-emitting device having a configuration in which an acceptor-containing layer is present between a cathode and a luminescent medium.
In this device configuration, however, there is a large difference in electron affinity (i.e. about 1 eV) between the acceptor layer and the electron-transporting layer, forming a barrier for electron injection. Therefore, a high voltage is required to be applied. For this reason, satisfactory emission cannot be attained even when a negative bias voltage is applied.
Patent Document 1: WO2005/109542
Patent Document 2: JP-A-H4-230997
An object of the invention is to provide an organic light-emitting device which has a high efficiency and a long lifetime and can reduce power consumption.

DISCLOSURE OF THE INVENTION

The invention can provide the following organic light-emitting device.

1. An organic light-emitting device comprising, arranged in the following order: an anode, an emitting,layer, a donor-containing layer, an acceptor-containing layer and a cathode,
the donor-containing layer containing at least one selected from a donor metal, a donor metal compound and a donor metal complex.
2. The organic light-emitting device according to 1, wherein the donor metal is an alkali metal, an alkaline earth metal or a rare earth metal.
3. The organic light-emitting device according to 1, wherein the donor metal compound is a halide, an oxide, a carbonate or a borate of an alkali metal, an alkaline earth metal or a rare earth metal.
4. The organic light-emitting device according to 1, wherein the donor metal complex is a complex of an alkali metal, an alkaline earth metal or a rare earth metal.
5. The organic light-emitting device according to any one of 1 to 4, wherein the donor-containing layer is a light-transmissive high-resistance layer.
6. The organic light-emitting device according to any one of 1 to 5, wherein an acceptor contained in the acceptor-containing layer is an organic compound having an electron-attracting substituent or an electron-deficient ring.
7. The organic light-emitting device according to 6, wherein the acceptor is a quinodimethane-based organic compound.
8. The organic light-emitting device according to any one of 1 to 7, wherein the acceptor-containing layer is a thin film having a thickness of 1 to 100 nm and has a transmittance of 80% or more for visible rays with a wavelength of 450 to 650 nm.

9. The organic light-emitting device according to any one of 1 to 8, wherein a buffer layer is between the cathode and the acceptor-containing layer.
10. The organic light-emitting device according to 9, wherein the buffer layer contains a hole-transporting material.
11. The organic light-emitting device according to 10, wherein the hole-transporting material is a metal oxide and/or a metal nitride.
12. The organic light-emitting device according to any one of 1 to 11, wherein the emitting layer contains a blue-emitting component.
13. The organic light-emitting device according to any one of 1 to 12, wherein the cathode is light-transmissive.

According to the invention, an organic light-emitting device which has a high efficiency and a long lifetime and can reduce power consumption can be provided.

BRIEF DESCRIPTION OF THE DRAWINGS

FIG. 1 is a view showing a first embodiment of an organic light-emitting device according to the invention; and
FIG. 2 is a view showing a second embodiment of an organic light-emitting device according to the invention.

BEST MODE FOR CARRYING OUT THE INVENTION

The organic light-emitting device of the invention comprises, arranged in the following order: an anode, an emitting layer, a donor-containing layer, an acceptor-containing layer and a cathode. FIG. 1 shows the device configuration of the first embodiment of the organic light-emitting device according to the invention.
As shown in FIG. 1, an organic light-emitting device 1 has a configuration in which an anode 10, a hole-injecting layer 20, a hole-transporting layer 30, an emitting layer 40, a donor-containing layer 50, an acceptor-containing layer 60 and a cathode 70 are stacked in this order.
In the invention, the acceptor-containing layer 60 is a layer which withdraws (accepts) electrons from the cathode 70, and transports the electrons to the donor-containing layer 50. In ordinary organic light-emitting devices, to enable electrons to be injected from the cathode to organic substances, a substance which has a small work function is used as the material for the cathode. For example, a stacked layer of LiF and Al is widely known as the cathode. Since the work function of Al is not so small, if the cathode is made only of Al, the driving voltage of the emitting device will be large as compared with the case where a LiF/Al stacked layer is used as the cathode. On the other hand, by providing the acceptor-containing layer 60 as in the case of the organic light-emitting device of the invention, an increase in driving voltage can be suppressed without using LiF.
The donor-containing layer 50 is a layer which withdraws electrons from the acceptor-containing layer 60 and inject (donate) the electrons to the emitting layer 40. Provision of the donor-containing layer 50 enables electrons to be accepted more easily from the acceptor layer 60, leading to a decrease in driving voltage, an increase in efficiency and a prolonged lifetime.
In this device 1, the acceptor contained in the acceptor-containing layer 60 withdraws electrons from a contacting surface between the acceptor-containing layer 60 and the cathode 70. Since the acceptor-containing layer 60 has electron-transportability, the electrons are transported from the contacting surface to the acceptor-containing layer 60 in the direction of the donor-containing layer 50. The electrons are then injected from the donor-containing layer 50 towards the emitting layer 40. On the other hand, holes are injected from the anode 10 to the hole-injecting layer 20, the hole-transporting layer 30, and further to the emitting layer 40. In the emitting layer 40, the holes and electrons are recombined to emit light.
In the organic light-emitting device of the invention, by providing the donor-containing layer 50, a large difference in affinity level between the emitting layer 40 and the acceptor-containing layer 60 can be eliminated.
If the donor-containing layer 50 is not provided, a high voltage must be applied since difference in affinity level between the acceptor-containing layer 60 and the emitting layer 40 is large. For this reason, an organic light-emitting device with such a device configuration cannot exhibit good emission performance even though a negative bias voltage is applied to the cathode.
In the invention, by providing the acceptor-containing layer 60 and the donor-containing layer 50 between the cathode 70 and the emitting layer 40, transportation of electrons can be facilitated, and an organic light-emitting device which can be driven at a low voltage, has a high degree of efficiency and a long lifetime can be obtained.
In the organic EL device, if the acceptor-containing layer contains a compound which is hardly damaged by sputtering which is conducted for forming a transparent electrode composed of ITO (indium tin oxide) or the like, it is not required to use a ultrathin film of LiF or the like in combination with ITO.

The affinity level can be determined by reducing an energy gap value from the value of an ionization potential. The energy gap can be determined by the wavelength of the absorption spectrum edge.
The ionization potential can be measured directly by photoelectron spectroscopy, or can be obtained by correcting, with respect to a reference electrode, an oxidation potential which has been electrochemically measured. In the latter method, if a saturated calomel electrode (SCE) is used as a reference electrode, the ionization potential can be expressed by the following formula (Molecular Semiconductors, Springer-Verlag, 1985, Page 98).

[Ionization potential] = [Oxidation potential (vs. SCE)] + 4.3 eV

The ionization potential can be obtained by the same expression as given above using a reduction potential which is electrochemically measured.
In the invention, the ionization potential is measured by an atmosphere photoelectron spectroscopic method or by an electrochemical method, and the affinity level is obtained from the thus obtained ionization potential.
In the case of a metal material used in the cathode, instead of the term "affinity level", "work function" is generally used.
The emitting layer of the organic light-emitting device of the invention preferably contains blue-emitting components.
The organic EL device of the invention may be either of top-emission type or bottom-emission type. In either type, the cathode is rendered transparent when light is outcoupled from the cathode side of the device. It is preferred that the cathode have a light transmission in the visible range (450 to 650 nm) of 50% or more.
The donor-containing layer and the acceptor-containing layer will be mentioned later.
The second embodiment of the organic light-emitting device of the invention will be explained below.
FIG. 2 is a cross sectional view showing the second embodiment of the organic EL device according to the invention.
This embodiment differs from the first embodiment in that a buffer layer 80 is provided between the acceptor-containing layer 60 and the cathode 70.
The buffer layer is a layer which itself generates carriers or a layer which itself contains carriers. Specific examples of the buffer layer include a dope layer, a conductive or semi-conductive inorganic compound layer, an alkaline metal layer, a metal halide layer, a metal complex layer or a combination thereof, and a combination of a metal complex layer and an Al thin film layer or the like which reacts with the metal complex layer.
Since the buffer layer contains carriers (electrons or holes) which contribute electric conductance, less energy is required for withdrawing electrons in the acceptor-containing layer, resulting in a further reduction in applied voltage.
The buffer layer preferably contains a hole-transporting material such as a metal oxide and metal nitride. If the buffer layer contains a hole-transporting material, electrons are withdrawn by the acceptor-containing layer,' and as a result, holes are generated easily. The holes are transported to the cathode by the applied voltage.
Examples of the metal oxide include $MoO_x$, $WO_x$, $VO_x$, $ReO_x$, $MnO_x$, $RuO_x$, $NbO_x$, $TaO_x$ and $TiO_x$ (x=1 to 4). Examples of the metal nitride include $MoN_x$, $WN_x$, $VN_x$, $MnN_x$, $NbN_x$, $TaN_x$ and $TiN_x$ (x=1 to 4).
These compounds may be used singly or in combination of two or more.
The configuration of the organic light-emitting device of the invention is not limited to those shown in FIG. 1 and FIG. 2. For example, the hole-transporting layer and the hole-injecting layer may be omitted since they are optional layers. Furthermore, an electron-transporting layer or the like may be provided.
Then, the donor-containing layer will be explained.
In the organic light-emitting device of the invention, the donor-containing layer is a layer which contains as a donor at least one selected from a donor metal, a donor metal compound and a donor metal complex.
The donor metal is a metal which has a work function of 3.8 eV or less. Preferable donor metals are an alkali metal, an alkaline earth metal and a rare earth metal. More preferable donor metal is Cs, Li, Na, Sr, K, Mg, Ca, Ba, Yb, Eu and Ce.
The donor metal compound is a compound which contains the above-mentioned donor metal. Preferable donor metal compounds are compounds containing an alkali metal, an alkaline earth metal or a rare earth metal. More preferable donor metal compounds are halides, oxides, carbonates and borates of these metals. For example, the donor metal compound is a compound shown by $MO_x$ (M is a donor metal, and x is 0.5 to 1.5), $MF_x$ (x is 1 to 3) or $M(CO_3)_x$ (x is 0.5 to 1.5).
The donor metal complex is a complex of the above-mentioned donor metal, preferably an organic metal complex of an alkaline metal, an alkaline earth metal or a rare earth metal. Preferably, an organic metal complex represented by the following formula (I):

$$M\!-\!\left(Q\right)_n \qquad (I)$$

wherein M is a donor metal, Q is a ligand, preferably an carboxylic acid derivative, a diketone derivative and a quinoline derivative, and n is an integer of 1 to 4.
Specific examples of the donor metal complex include a tungsten paddlewheel $[W_2(hhp)_4$(hpp:1,3,4,6,7,8-hexahydro-24-pyrimide [1,2-a]pyrimidine) disclosed in JP-A-2005-72012. In addition, a phthalocyanine compound having an alkali metal or an alkaline earth metal as a central metal as disclosed in JP-A-11-345687 may be used as a donor metal complex.

The above-mentioned donors may be used singly or in combination of two or more.
The content of a donor contained in the donor-containing layer is 1 to 100 mol%, more preferably 50 to 100 mol%.
In addition to the above-mentioned donor, the donor layer may contain one or a plurality of substances insofar as the substance is light-transmissive. Specific examples of such a substance include, though not limited thereto, organic substances such as an amine compound, a condensed ring compound, a nitrogen-containing heterocyclic compound and a metal complex and inorganic substances such as metal oxides, metal nitrides, metal fluorides and carbonates.
The thickness of the donor-containing layer is preferably 1 to 100 nm.

The donor-containing layer is preferably a high-resistance layer.
Due to the high resistance thereof, the donor-containing layer is capable of suppressing conductance of electricity in the direction perpendicular to the thickness of the layer.
In addition, when light is outcoupled through the donor-containing layer, it is preferred that the donor-containing layer have a high degree of light transmissibility.

Having light transmissibility means having transmittance for visible rays with a wavelength of 450 to 650 nm of 10% or more, preferably 30% or more, more preferably 50% or more. Light transmissibility can be determined by the following method, for example. A layer to be examined for light transmissibility is provided, for example, on a flat, Light-transmissible substrate. The layer is then irradiated with light, and the ratio of the intensity of transmitted light to the intensity of irradiated light is obtained. From the thus obtained ratio, the ratio of the intensity of transmitted light to the intensity of irradiated light obtained for the substrate alone is deducted.
As for the electrical resistance, it is preferred that the specific resistance be $10^{-1}\Omega\cdot cm$ or more. The specific resistance can be determined by the following method. Parallel electrode stripes are provided on a flat insulating substrate, and a light-transmissive high-resistance layer is provided thereon, and the current-voltage characteristics thereof are measured.

The light-transmissive high-resistance layer may contain, in addition to the donor, a transition metal oxide, a metal complex such as Alq or the like. It is preferred that the light-transmissive high-resistance layer contain a mixture of a donor metal element and a transition metal oxide. More preferably, the light-transmissive high-resistance layer contains a mixture of an alkali metal and $MoO_x$ (x is 1 to 4).

Then, the acceptor-containing layer will be explained.
An acceptor is an easily-reducible organic compound. Reducibility of a compound can be measured by a reduction potential. In the invention, in terms of a reduction potential measured by using a saturated calomel (SCE) electrode as a reference electrode, it is preferred that the acceptor have a reduction potential of -0. 8V or more, more preferably -0.3V or more. A compound having a reduction potential larger than the reduction potential of tetracyanoquinodimethane (TCNQ) (about 0V) is particularly preferable as the acceptor.

The acceptor is preferably an organic compound having an electron-attracting substituent or an electron-deficient ring.
As the electron-attracting substituent, halogen, CN-, carbonyl, aryl boron or the like can be given.
Examples of the electron-deficient ring include, though not limited thereto, 2-pyridyl, 3-pyridyl, 4-pyridyl, 2-quinolyl, 3-quinolyl, 4-quinolyl, 2-imidazole, 4-imidazole, 3-pyrazole, 4-pyrazole, pyridazine, pyrimidine, pyrazine, cinnoline, phthalazine, quinazoline, quinoxaline, 3-(1,2,4-N)-triazolyl, 5-(1,2,4-N)-triazolyl, 5-tetrazolyl, 4-(1-O, 3-N)-oxazole, 5-(1-O, 3-N)-oxazole, 4-(1-S, 3-N)-thiazole, 5-(1-S, 3-N)-thiazole, 2-benzoxazole, 2-benzothiazole, 4-(1,2,3-N)-benzotriazole and benzimidazole.

The acceptor is preferably a quinoid derivative, more preferably a quinodimethane derivative.
As the preferable quinoid derivative, compounds shown by the following formulas (1a) to (1i) can be given, with compounds shown by formulas (1a) and (1b) being more preferable.

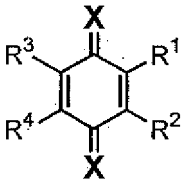
(1a)

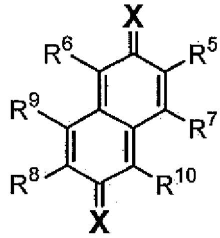
(1b)

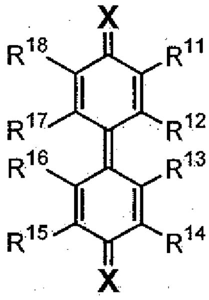
(1c)

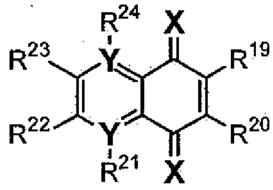
(1d)

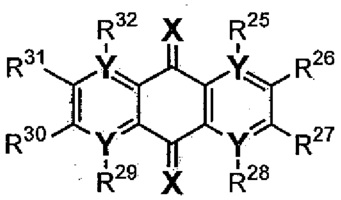
(1e)

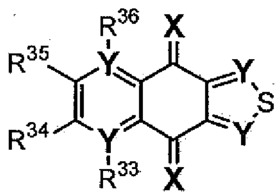
(1f)

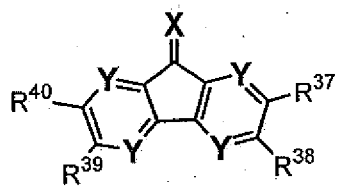
(1g)

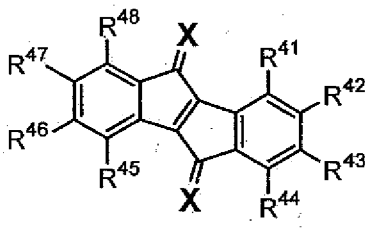
(1h)

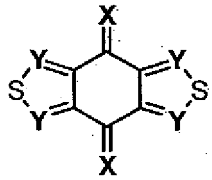
(1i)

In the formulas (1a) to (1i), $R^1$ to $R^{48}$ are independently hydrogen, halogen, fluoroalkyl, cyano, alkoxy, alkyl or aryl. Preferably, $R^1$ to $R^{43}$ are hydrogen or cyano.
In the formulas (1a) to (1i), X is an electron-attracting group and has any one of the structures shown by the following formulas (j) to (p). The structures shown by the formulas (j), (k) and (l) are preferable.

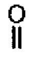
(j)

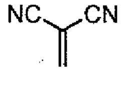
(k)

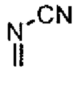
(l)

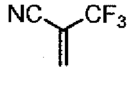
(m)

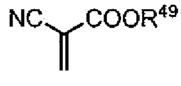
(n)

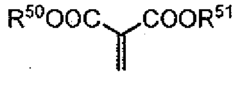
(o)

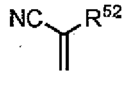
(p)

wherein $R^{49}$ to $R^{52}$ are independently hydrogen, fluoroalkyl, alkyl, aryl or heterocycle, and $R^{50}$ and $R^{51}$ may form a ring.
In the formulas (1a) to (1i), Y is -N= or -CH=.
As the halogen shown by $R^1$ to $R^{48}$, fluorine and chlorine are preferable.
As the fluoroalkyl group shown by $R^1$ to $R^{48}$, trifluoromethyl and pentafluoroethyl are preferable.
As the alkoxy group shown by $R^1$ to $R^{48}$, methoxy, ethoxy, iso-propoxy and tert-butoxy are preferable.

As the alkyl group shown by $R^1$ to $R^{48}$, methyl, ethyl, propyl, iso-propyl, tert-butyl and cyclohexyl are preferable. As the aryl group shown by $R^1$ to $R^{48}$, phenyl and napthyl are preferable.

The fluoroalkyl, alkyl and aryl shown by $R^{49}$ to $R^{52}$ are the same as those for $R^1$ to $R^{48}$.

As the heterocycle shown by $R^{49}$ to $R^{52}$, the substituents shown by the following formulas are preferable.

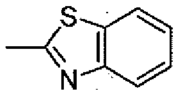
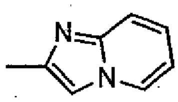
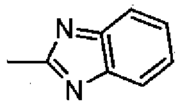

If $R^{50}$ and $R^{51}$ form a ring, X is preferably a substituent shown by the following formula.

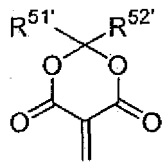

wherein $R^{51'}$ and $R^{52'}$ are independently methyl, ethyl, propyl and tert-butyl.

Specific examples of the quinoid derivative include the compounds shown below.

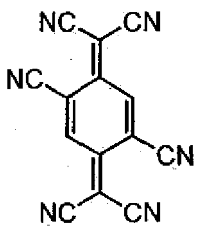
(CN)2-TCNQ
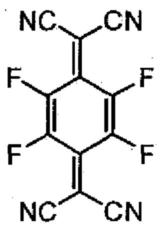
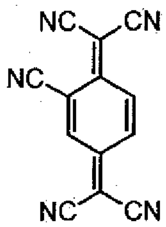
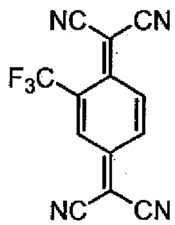
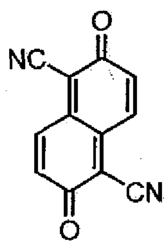
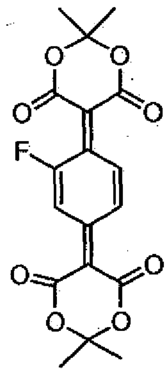

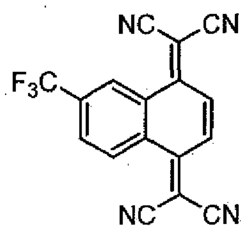
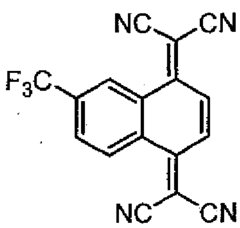
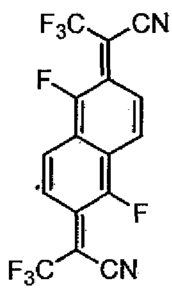
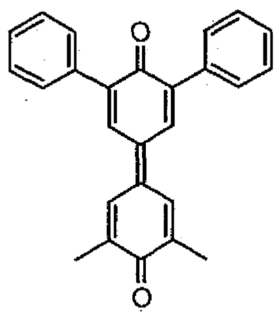

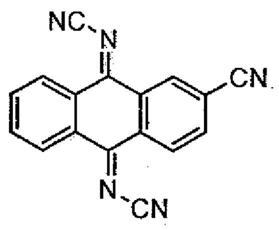

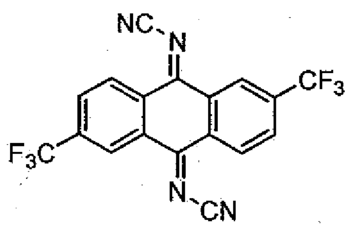

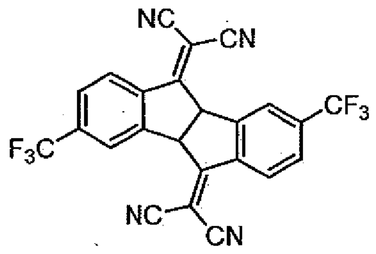

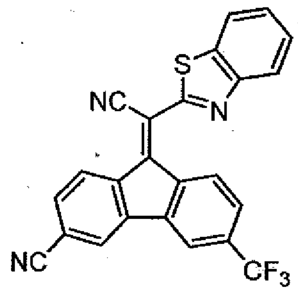

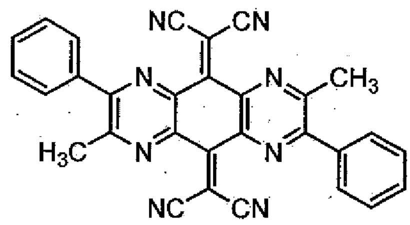

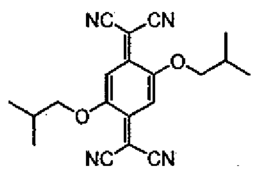

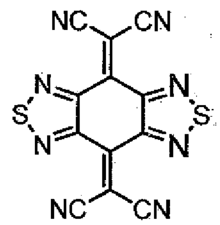

It is preferred that the acceptor be capable of forming a thin film. That is, the acceptor-containing layer can be formed by vapor deposition. Here, the expression "capable of forming a thin film" means that a smooth thin film can be formed on a substrate by common thin film-forming methods such as vacuum vapor deposition and spin coating. Specifically, a smooth thin film (thickness: 1 nm to 100 nm) can be formed on a glass substrate. Here, the expression "smooth" means the degree of unevenness of a thin film is small. It is preferred that the thin film have a surface roughness (Ra) of 10 nm or less, more preferably 1.5 nm of less, and more preferably 1 nm or less. The surface roughness can be measured by means of an atomic force microscope (AFM).

Organic compounds capable of forming a thin film are preferably amorphous organic compounds, more preferably amorphous quinodimethane derivatives, further preferably amorphous quinodimethane derivatives having 5 or more CN-groups. Examples include the above-mentioned $(CN)_2$-TCNQ.

The content of the acceptor in the acceptor-containing layer is preferably 1 to 100 mol%, more preferably 50 to 100 mol%, relative to the entire layer.

In addition to the acceptor, the acceptor-containing layer may contain a hole-transporting and light-transmissive material. The material is, however, not limited thereto.

A donor may be added to the acceptor-containing layer in order to facilitate injection of electrons to the donor-containing layer or in order to facilitate transportation of holes to the cathode. The donor is a compound capable of donating electrons to other compounds than the donor contained in the acceptor-containing layer or to compounds contained in a layer adjacent to the acceptor-containing layer.

As for the donor, other than the donor metals mentioned above, organic donor compounds such as amine compounds, polyamine compounds and tungsten complexes can be mentioned.

The thickness of the acceptor-containing layer is preferably 1 to 100 nm.

When light is outcoupled through the acceptor-containing layer, the acceptor-containing layer is light transmissive. The

light transmission of the acceptor-containing layer in the visible range (450 to 650 nm) is preferably 50% or more, more preferably 80% or more.

## EXAMPLES

<Compound>

The compounds used in Examples and Comparative Examples are shown below.

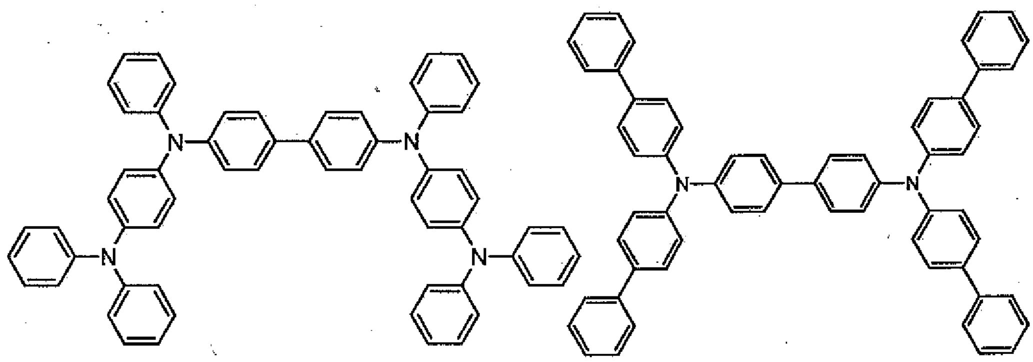

TPD232 TBDB

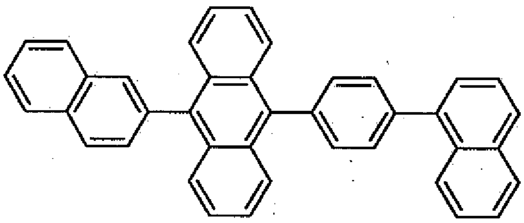

BH

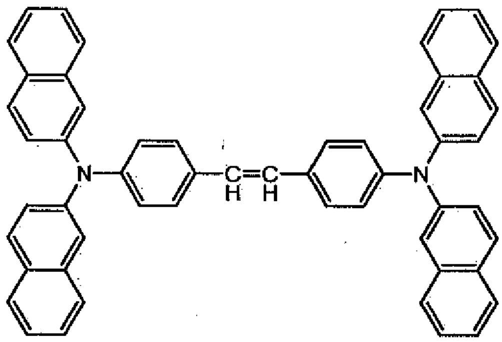

BD

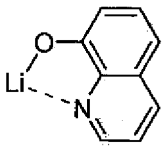

Liq

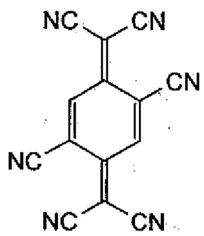

$(CN)_2TCNQ$

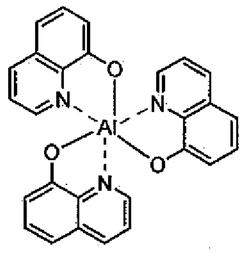

Alq

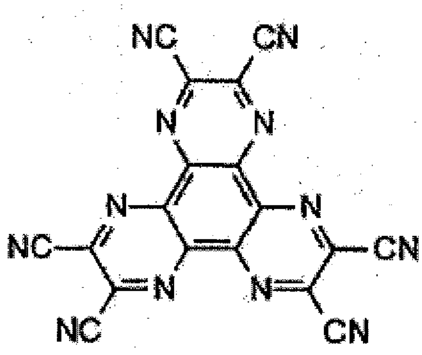

HAT

<Reduction potential of a material used in the acceptor-containing layer>

A cyclic voltammetric measurement was conducted for $(CN)_2TCNQ$ used as a material for forming an acceptor-containing layer wherein a saturated calomel electrode (SCE) was used as a reference electrode. The reduction potential thereof was found to be 0.71 V.

<Evaluation method>

(1) Driving voltage

A voltage (unit: V) when electricity was passed through between ITO and Al such that the current density became 10 $mA/cm^2$ was measured.

(2) Luminous efficiency

An EL spectrum when a voltage was applied such that the current density became 10 $mA/cm^2$ was measured by means of a spectroradiometer (CS1000A, manufactured by Konica Minolta) and a luminous efficiency (unit: cd/A) was calculated.

(3) Half life

The organic light-emitting device was driven at a constant DC current at room temperature. The current value was set such that an initial luminance became 5,000 $cd/m^2$, and time dependency of the luminance was measured. The time required for the initial luminance to decrease by half was defined as the half life.

(4) Light transmittance

A layer for measurement (thickness: 1 to 100 nm) was formed on a flat, light-transmissive glass substrate (thickness: 0.7 mm). The layer was then irradiated with light, and the ratio of the intensity of the transmitted light to the intensity of the irradiated light was obtained. From this value, the ratio of the intensity of the transmitted light to the intensity of the irradiated light measured for the substrate alone was deducted. The resulting ratio was defined as the light transmittance.

(5) Specific resistance

On a flat, insulating glass substrate, two parallel electrode stripes (gap between the electrodes: 1 mm) were provided. On the electrode stripes, a layer for measurement (thickness: 100 nm) was provided. A voltage of -10V to +10V was swept across the two electrode stripes to measure current values, and a specific resistance was obtained from the gradient of the current-voltage characteristics.

Example 1

An ITO film was formed on a 0.7 mm-thick glass substrate by sputtering in a thickness of 130 nm. The substrate was subjected to ultrasonic cleaning in isopropyl alcohol for 5 minutes, and cleaned with ultraviolet ozone for 30 minutes. Then, the substrate with the ITO electrode was mounted on a substrate holder in a vacuum vapor deposition apparatus. TPD232 as a material for a hole-injecting layer, TBDB as a material for a hole-transporting layer, BH as a host material for an emitting layer, BD as a blue emitting material, Alq as an electron-transporting material, Li as a donor, $(CN)_2$TCNQ as an acceptor and Al as a cathode material were mounted on respective molybdenum heating boats in advance.

First, a TPD232 film which functioned as the hole-injecting layer was formed in a thickness of 60 nm. After forming the hole-injecting layer, a TBDB film which functioned as the hole-transporting layer was formed in a thickness of 20 nm. Then, the compound BH and the compound BD were co-deposited in a thickness of 40 nm at a ratio of 40:2 as the emitting layer. An $Alq_3$ film was formed on the above film in a thickness of 10 nm as the electron-transporting layer. Then, a Li film (light transmittance: 90%, specific resistance: $10^{-5}$ Ω·cm) was deposited in a thickness of 1 nm as the acceptor-containing layer, and an Al film which functioned as the cathode was formed on the above film in a thickness of 150 nm to obtain an organic light-emitting device.

Evaluation was conducted for the resulting organic light-emitting device. The results are shown in Table 1.

Example 2

An organic light-emitting device was fabricated in the same manner as in Example 1, except that, in Example 1, the donor-containing layer (light transmittance: 90%, specific resistance: $10^{14}$ Ω·cm) was formed by using Liq as the donor instead of Li.

Evaluation was conducted for the resulting organic light-emitting device. The results are shown in Table 1.

Example 3

An organic light-emitting device was fabricated in the same manner as in Example 2, except that, in Example 1, after formation of the acceptor layer, a 10 nm-thick buffer layer was formed using $MoO_x$ (x=2 to 3) as a material for a buffer layer, followed by the formation of an Al film (cathode).

Evaluation was conducted for the resulting organic light-emitting device. The results are shown in Table 1.

Example 4

An organic light-emitting device was fabricated in the same manner as in Example 1, except that, in Example 1, $MoO_x$ (x=2 to 3) and Cs were used as the donor instead of Li, $MoO_x$ (x=2 to 3) and Cs were co-deposited in a film thickness of 10 nm at the ratio of 10:1 to form a donor-containing layer (light transmittance: 90%, specific resistance: $10^8$ Ω·cm), and an acceptor-containing layer (light transmittance: 80%) was formed using $(CN)_2$TCNQ as the acceptor.

Evaluation was conducted for the resulting organic EL device. The results are shown in Table 1.

Example 5

An organic light-emitting device was fabricated in the same manner as in Example 1, except that Alq and Li were used as the donor and Alq and Li was co-deposited in a film thickness of 10 nm in a ratio of 10:0.3 to form a donor-containing layer (light transmittance: 90%, specific resistance: $10^{10}$ Ω · cm).

Evaluation was conducted for the resulting organic EL device. The results are shown in Table 1.

Comparative Example 1

An organic light-emitting device was fabricated in the same manner as in Example 1, except that the Li layer (donor-containing layer) was not formed.

Evaluation was conducted for the resulting organic EL device. The results are shown in Table 1.

Comparative Example 2

An ITO film was formed on a 0.7 mm-thick glass substrate by sputtering in a thickness of 130 nm. The substrate was subjected to ultrasonic cleaning in isopropyl alcohol for 5 minutes, and cleaned with ultraviolet ozone for 30 minutes. Then the substrate with the ITO electrode was mounted on a substrate holder in a vacuum vapor deposition apparatus. HAT as an acceptor, TBDB as a material for a hole-transporting layer, BH as a host material for an emitting layer, BD

as a blue emitting material, Alq as an electron-transporting material, Li as a donor, and Al as a cathode material were mounted on respective molybdenum heating boats in advance.

First, a HAT film which functioned as the acceptor-containing layer was formed in a thickness of 10 nm. After forming the acceptor-containing layer, a TBDB film which functioned as the hole-transporting layer was formed in a thickness of 70 nm. Then, the compound BH and the compound BD were co-deposited in a thickness of 40 nm at a ratio of 40:2 as the emitting layer. An Alq film was formed on the above film in a thickness of 20 nm as the electron-transporting layer. Then a Li film was deposited in a thickness of 1 nm as the donor-containing layer, and an Al film which functioned as the cathode was formed on the above film in a thickness of 150 nm to obtain an organic light-emitting device. In Comparative Example 2, emitting performance was evaluated by applying a negative bias voltage to ITO adjacent to HAT. Evaluation was conducted for the resulting organic light-emitting device. The results are shown in Table 1.

Table 1

| | Example 1 | Example 2 | Example 3 | Example 4 | Example 5 | Com. Ex. 1 | Com. Ex. 2 |
|---|---|---|---|---|---|---|---|
| Substrate | Glass substrate | Glass substrate | Glass substrate | Glass substrate | Glass substrate | Glass substrate | Glass substrate |
| Anode | ITO | ITO | ITO | ITO | ITO | ITO | ITO |
| Hole-injecting layer | TPD232 | TPD232 | TPD232 | TPD232 | TPD232 | TPD232 | - |
| Acceptor-containing layer | - | - | - | - | - | - | HAT |
| Hole-transporting layer | TBDB | TBDB | TBDB | TBDB | TBDB | TBDB | TBDB |
| Emitting layer | BH:BD | BH:BD | BH:BD | BH:BD | BH:BD | BH:BD | BH:BD |
| Electron-transporting layer | Alq | Alq | Alq | Alq | Alq | Alq | Alq |
| Donor-containing layer | Li | Liq | Liq | $MoO_x$:Cs | Alq:Li | - | Li |
| Acceptor-containing layer | $(CN)_2$TCNQ | $(CN)_2$TCNQ | $(CN)_2$TCNQ | $(CN)_2$TCNQ | $(CN)_2$TCNQ | $(CN)_2$TCNQ | - |
| Buffer layer | - | - | $MoO_x$ | - | - | - | - |
| Cathode | Al | Al | Al | Al | Al | Al | Al |
| Driving voltage (V) | 5 | 5 | 5 | 5 | 5 | 10 | 20 |
| Luminous efficiency (cd/A) | 6 | 6 | 6 | 6 | 6 | 4 | 1 |
| Half life (hour) | 700 | 700 | 700 | 700 | 700 | 100 | 10 |

INDUSTRIAL APPLICABILITY

The organic light-emitting device of the invention can be used as a light source of a display, an illuminator or the like.

## Claims

1. An organic light-emitting device comprising, arranged in the following order: an anode, an emitting layer, a donor-containing layer, an acceptor-containing layer and a cathode,
the donor-containing layer containing at least one selected from a donor metal, a donor metal compound and a donor metal complex.

2. The organic light-emitting device according to claim 1, wherein the donor metal is an alkali metal, an alkaline earth metal or a rare earth metal.

3. The organic light-emitting device according to claim 1, wherein the donor metal compound is a halide, an oxide, a carbonate or a borate of an alkali metal, an alkaline earth metal or a rare earth metal.

4. The organic light-emitting device according to claim 1, wherein the donor metal complex is a complex of an alkali metal, an alkaline earth metal or a rare earth metal.

5. The organic light-emitting device according to any one of claims 1 to 4, wherein the donor-containing layer is a light-transmissive high-resistance layer.

6. The organic light-emitting device according to any one of claims 1 to 5, wherein an acceptor contained in the acceptor-containing layer is an organic compound having an electron-attracting substituent or an electron-deficient ring.

7. The organic light-emitting device according to claim 6, wherein the acceptor is a quinodimethane-based organic compound.

8. The organic light-emitting device according to any one of claims 1 to 7, wherein the acceptor-containing layer is a thin film having a thickness of 1 to 100 nm and has a transmittance of 80% or more for visible rays with a wavelength of 450 to 650 nm.

9. The organic light-emitting device according to any one of claims 1 to 8, wherein a buffer layer is between the cathode and the acceptor-containing layer.

10. The organic light-emitting device according to claim 9, wherein the buffer layer contains a hole-transporting material.

11. The organic light-emitting device according to claim 10, wherein the hole-transporting material is a metal oxide and/or a metal nitride.

12. The organic light-emitting device according to any one of claims 1 to 11, wherein the emitting layer contains a blue-emitting component.

13. The organic light-emitting device according to any one of claims 1 to 12, wherein the cathode is light-transmissive.

FIG. 1

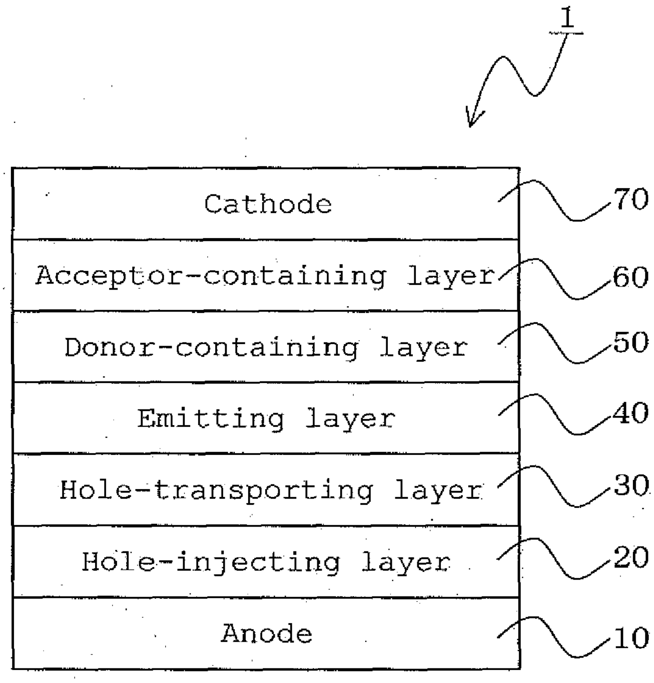
1
Cathode
Acceptor-containing layer
Donor-containing layer
Emitting layer
Hole-transporting layer
Hole-injecting layer
Anode
70
60
50
40
30
20
10

FIG. 2

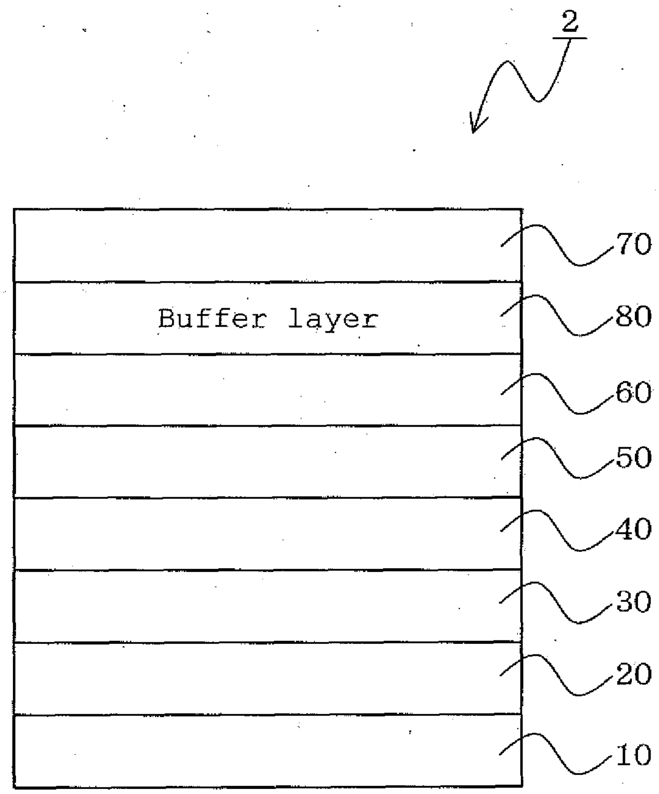
2
Buffer layer
70
80
60
50
40
30
20
10

**INTERNATIONAL SEARCH REPORT**

International application No. PCT/JP2007/058146

A. CLASSIFICATION OF SUBJECT MATTER
*H01L51/50*(2006.01)i, *C09K11/06*(2006.01)i

According to International Patent Classification (IPC) or to both national classification and IPC

B. FIELDS SEARCHED

Minimum documentation searched (classification system followed by classification symbols)
H01L51/50, C09K11/06

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2006-074022 A (Semiconductor Energy Laboratory Co., Ltd.), 16 March, 2006 (16.03.06), Par. Nos. [0017] to [0023], [0070] to [0083], [0091], [0109], [0146]; Figs. 1, 3, 7, 10 & US 2006/0027830 A1 & EP 1624502 A2 | 1-2,5-9, 12-13<br>3-4<br>10-11 |
| Y | WO 2005/086539 A1 (Idemitsu Kosan Co., Ltd.), 15 September, 2005 (15.09.05), Par. No. [0102] & EP 1722604 A | 3-4 |
| P,X | JP 2006-156997 A (Semiconductor Energy Laboratory Co., Ltd.), 15 June, 2006 (15.06.06), Full text; all drawings & WO 2006/049323 A1 | 1-3,5-8, 12-13 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 09 May, 2007 (09.05.07) | 29 May, 2007 (29.05.07) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.
PCT/JP2007/058146

C (Continuation). DOCUMENTS CONSIDERED TO BE RELEVANT

| Category* | Citation of document, with indication, where appropriate, of the relevant passages | Relevant to claim No. |
|---|---|---|
| A | JP 2003-178882 A (Semiconductor Energy Laboratory Co., Ltd.), 27 June, 2003 (27.06.03), Full text; all drawings & US 2003/0038594 A1 & CN 1407836 A | 1-13 |
| A | L.S.Hung, C.W.Tang and M.G.Mason, 'Enhanced electron injection in organic electroluminescence devices using an Al/LiF electr ode', Applied Physics Letters, vol.70, pages.152-154, 1997 | 1-13 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2005109542 A
- JP H4230997 A
- JP 2005072012 A
- JP 11345687 A